Europäisches Patentamt

European Patent Office

Office européen des brevets

(11) Publication number: **0 224 213**
**A2**

## (12) EUROPEAN PATENT APPLICATION

(21) Application number: 86116164.4

(22) Date of filing: 21.11.86

(51) Int. Cl.⁴: **H01L 27/10**

(30) Priority: 22.11.85 JP 264331/85
27.11.85 JP 267709/85
20.12.85 JP 288767/85

(43) Date of publication of application:
**03.06.87 Bulletin 87/23**

(84) Designated Contracting States:
**DE FR GB**

(71) Applicant: **NEC CORPORATION**
**33-1, Shiba 5-chome, Minato-ku**
**Tokyo 108(JP)**

(72) Inventor: **Tamakoshi, Akira c/o NEC**
**Corporation**
**33-1, Shiba 5-chome**
**Minato-ku Tokyo(JP)**
Inventor: **Inoue, Yasukazu c/o NEC**
**Corporation**
**33-1, Shiba 5-chome**
**Minato-ku Tokyo(JP)**
Inventor: **Hagiwara, Muneyuki c/o NEC**
**Corporation**
**33-1, Shiba 5-chome**
**Minato-ku Tokyo(JP)**

(74) Representative: **Glawe, Delfs, Moll & Partner**
**Patentanwälte**
**Postfach 26 01 62 Liebherrstrasse 20**
**D-8000 München 26(DE)**

(54) Semiconductor memory device.

(57) A semiconductor memory device comprising a memory array section in which a plurality of memory cells are provided and a peripheral circuit section in which many circuit elements are provided is disclosed. The memory array section is substantially surrounded by a capacitor.

Fig. 3

## SEMICONDUCTOR MEMORY DEVICE

Background of the Invention:

The present invention relates to a semiconductor memory device, and more particularly to a semiconductor memory device having a plurality of dynamic memory cells each including a switching transistor and a storage capacitor coupled to the switching transistor.

The storage capacitor is constituted by an upper electrode, a dielectric film under the upper electrode and a layer of one conductivity type (e.g., N-type) formed along the surface of a semiconductor substrate region of the opposite conductivity type (e.g., P-type) which is employed as the lower electrode of the storage capacitor. The N-type layer as the lower electrode can be formed beforehand in the surface of the P-type substrate. An information of High level (for example, a level of Vcc = +5 V) or Low level (for example, 0 V) is written in the storage capacitor from a digit line coupled to the switching transistor through the transistor. When High level (+5 V) is written in the storage capacitor, the N-type layer becomes an electron-lack state. However, if an insulated gate field effect transistor or a capacitor in a peripheral circuit is positioned in the vicinity of the memory cell and a high voltage is applied to the gate electrode of the transistor or the capacitor electrode in the peripheral circuit, electrons are generated in excess in the depletion layer under the electrode and the electrons are dispersed into the P-type substrate. The dispersed electrons, that is, minority carriers in the substrate are absorbed in the N-type layer of the storage capacitor so that the electron-lack state in the storage capacitor is changed to the electron-full state. Therefore, the high-level information stored in the memory cell is erroneously changed to the low-level one. This phenomenon happens in the memory device in which the N-type layers for the cell capacitors are formed beforehand and the upper capacitor electrode is fixed to a ground potential (0 V). However, this phenomenon is more serious in the case where the N-type inversion layer as a lower capacitor electrode is generated by the positive voltage - (Vcc) applied to the upper electrode of the storage capacitor.

To cope with this disadvantage, a groove may be provided in the substrate between the memory cell and the peripheral circuit. However, the groove is only used as a physical shield against the dispersed electrons and it is not effective means because the dispersed electrons from the depletion layer have high energy. Further, when the storage capacitor of the memroy cell employs a trench, the groove per se is no more effective as the countermeasure.

Summary of the Invention:

Accordingly, an object of the present invention is to provide a semiconductor memory device in which a written information is protected against adverse effect of the peripheral circuit.

According to one feature of the present invention, there is provided a semiconductor memory device comprising a semiconductor substrate, a memory cell array section provided in a first portion of the substrate and having a plurality of memory cells therein, a peripheral circuit section provided in a second portion of the substrate in the vicinity of the first portion with a peripheral circuit formed therein, and a capacitor substantially surrounding the memory cell array section.

According to another feature of the present invention, there is provided a semiconductor substrate having a major surface, a memory cell including a switching transistor and a storage capacitor coupled to the switching transistor, a circuit element belonging to a peripheral circuit, and an isolation capacitor positioned between the storage capacitor of the memory cell and the circuit element in the peripheral circuit. The storage capacitor may be formed in a first trench extending from the major surface of the substrate inward the substrate with a dielectric film attached to the side and bottom surfaces of the first trench and an upper electrode provided on the dielectric film, and the isolation capacitor may be formed in a second trench extending from the major surface of the substrate inward the substrate at the depth equal to or deeper than that of the first trench with a dielectric film attached to the side and bottom surfaces of the second trench and an upper electrode provided on the dielectric film. On the other hand, the storage capacitor of the memory cell may be formed along the flat major surface of the substrate, while the isolation capacitor between the storage capacitor and the circuit element may be formed along the flat major surface of the substrate. An impurity region of one conductivity type - (for example, N-type) may be formed in the substrate of the opposite conductivity type (for example, P-type) under the upper electrode of the capacitor. The impurity region may be an inversion layer generated by a power supply voltage (for example, positive voltage) applied to the upper electrode of the capacitor.

Brief Description of the Drawings:

Fig. 1 is a cross-sectional view showing a memory cell and a part of a pheripheral circuit in a prior art;

Fig. 2 is a plan view showing a semiconductor chip according to an embodiment of the present invention; and

Figs. 3, 4 and 5 are cross-sectional views showing first, second and third embodiments of the present invention, respectively.

Description of the Prior Art:

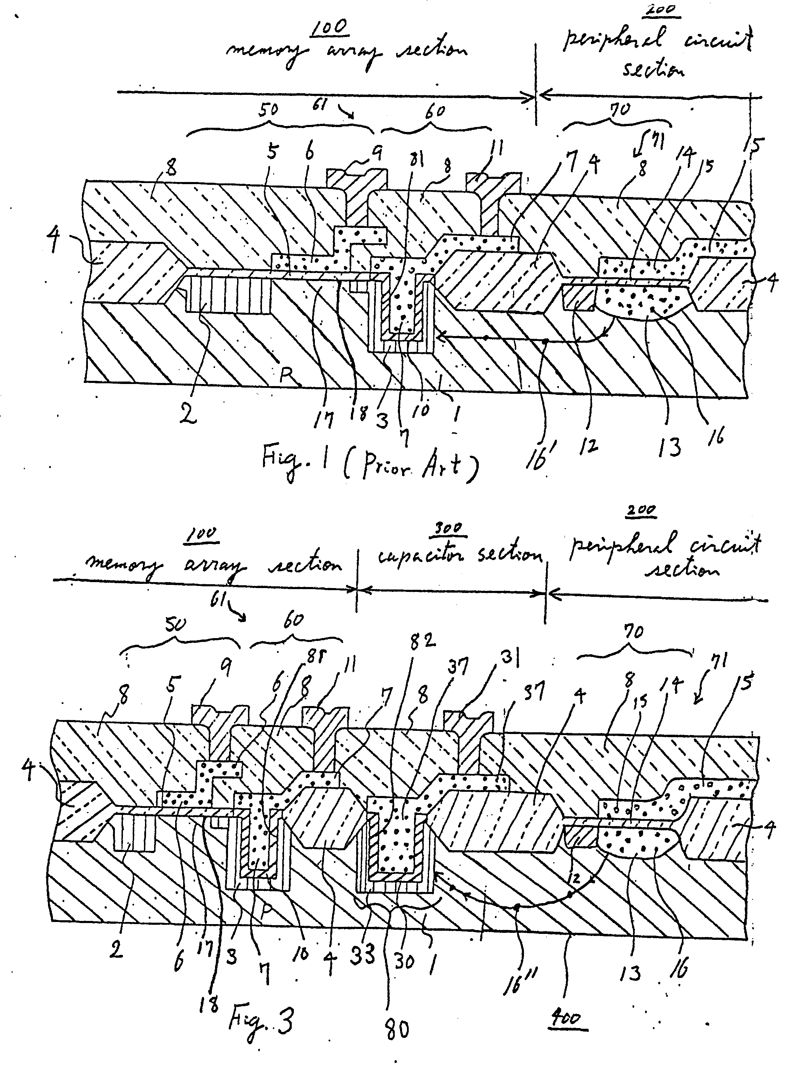

Referring to Fig. 1, a dynamic memory cell 61 consisting of one switching transistor 50 and one storage capacitor 60 coupled to the transistor 50 is installed in a memory cell array section 100 of a P-type silicon substrate 1 and adjacent to a thick and at least partially embedded field oxide layer 4. In the vicinity of the memory cell 61, an element 71 such as an insulating gate field effect transistor or a capacitor of a peripheral circuit 70 is provided. The switching transistor 50 includes an $N^+$-type source or drain region 2 coupled to a digit line (not shown) and formed in the silicon substrate 1, a channel region 17, a gate insulating film 5 provided on the channel region 17 and a gate electrode 6 of polycrystalline silicon formed on the gate insulating film 5 and connected to a word line 9 through an aperture provided in an intermediate insulating layer 8. The storage capacitor 60 includes a dielectric film 10 having the thickness 200 Å to 300 Å, made of a silicon oxide film or a composite film of silicon oxide and silicon nitride, and formed on side and bottom surfaces of a trench 81 which extends inwardly from the major surface 18 of the substrate at a distance of 5 to 6 $\mu$m and has a square plan shape of 1.5 $\mu$m x 1.5 $\mu$m. An upper electrode 7 of polycrystalline silicon is formed on the dielectric film 10 and extends on the thick field oxide layer 4 where a power supply wiring 11 is connected to. An N-type inversion layer 3 is produced along the trench 81 by applying a positive voltage such as Vcc of, for example, +5V to the upper electrode 7 through the power supply wiring 11. The capacitance of the storage capacitor 60 of the memory cell 61 becomes about 50 fF. The substrate 1 is connected to a ground line (0 V) or to a negative voltage line of -1V to -2V. The element 71 of the peripheral circuit 70 in the peripheral circuit section 200 includes an $N^+$-type region 12, a dielectric film 14 formed on the major surface of the substrate, an upper electrode, that is, a gate electrode 15 formed on the dielectric film 14. When a high positive voltage such as 7V to 8V, which is higher the power supply voltage Vcc of 5V, is applied to the gate electrode during an activation period of a word line, for example, a depletion layer 13, in which many of excess electrons 16 are induced, is produced. The electrons 16 having high energy are easily dispersed into the substrate, and the dispersed electrons 16' are attracted to the inversion layer 3 of the storage capacitor 60 of the memory cell. When the memory cell has been stored an information High level, the N-type inversion layer 3 has kept a state which lack electrons. Then, if a large amount of dispersed electrons 16' reach the N-type inversion layer 3, the layer 3 changes it's state from the electron-lack state to the electron-full state. That is, the High level information is erroneously changed to Low level.

Description of the Embodiments:

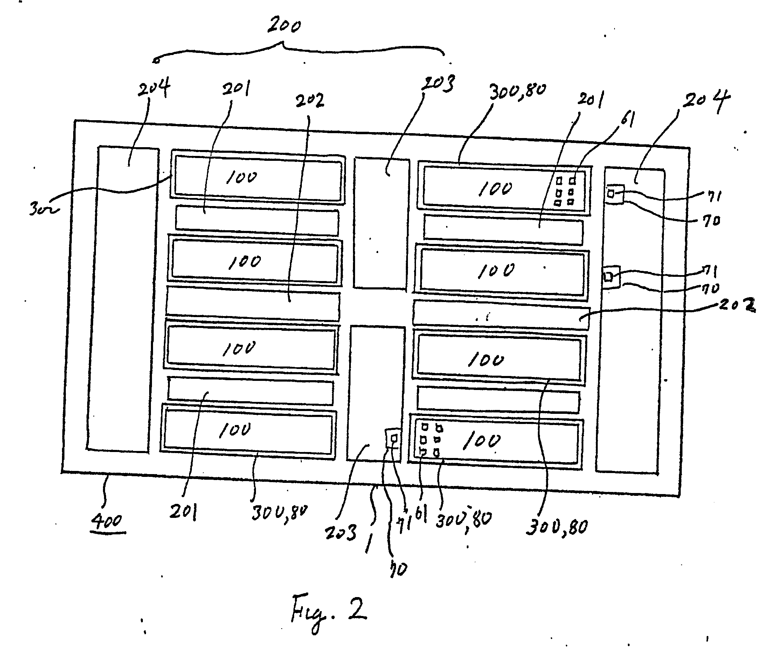

Referring to Fig. 2, a semiconductor memory device 400, that is, a memory chip comprises the P-type silicon substrate 1, memory cell array sections 100 provided in the substrate 1, peripheral circuit sections 200 provided in the substrate and including sence amplifier circuits 201, Y-decoders 202, X-decoders 203, and data input/output and other circuits 204. Each of memory array sections 100 has a plurality of dynamic memory cells 61 arranged in a matrix form. Also, in each of peripheral circuit sections, many of peripheral circuits 70 are provided, in which circuit elements 71 such as transistors and capacitors are formed. The semiconductor memory device 400 further comprises capacitor sections 300 according to the present invention in which capacitors 80 are formed. Each of the capacitors 80 according to the present invention substantially surrounds each of memory cell array sections 100.

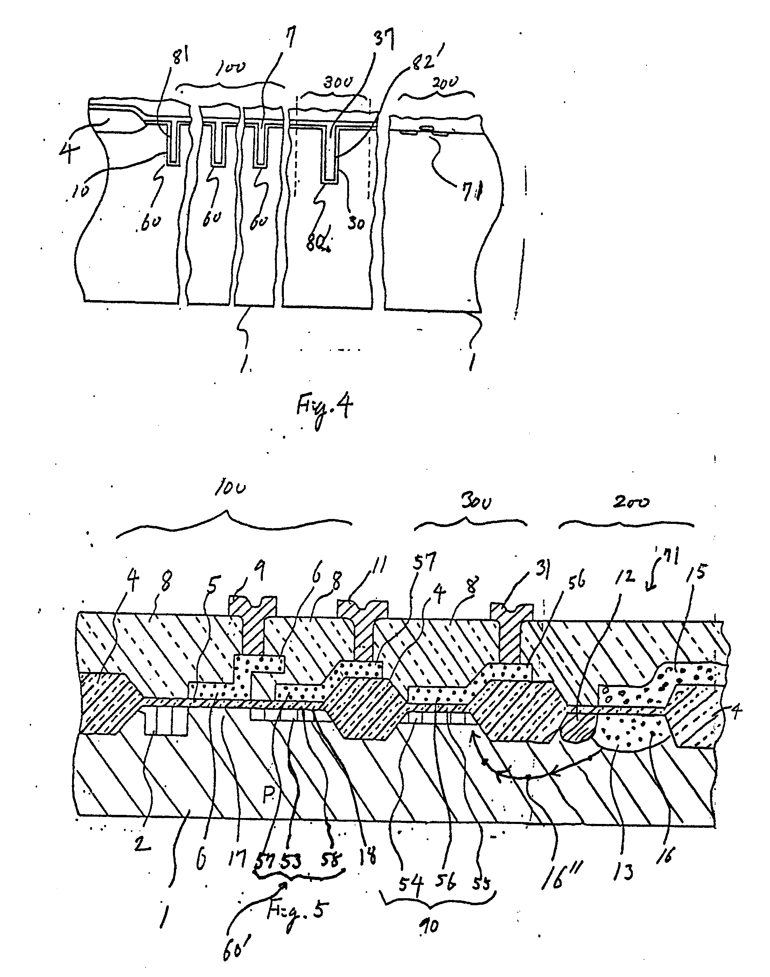

Referring to Fig. 3, which descloses only one memory cell 61 among many memory cells in the memory cell section 100 positioned near the peripheral circuit section 200, the same components as those in Figs. 1 and 2 are indicated by the same reference numerals. According to the present invention, the capacitor 80 is formed in the capacitor section 300 between the storage capacitor 60 of the memory cell 61 and the element 71 in the peripheral circuit 200. The capacitor 80 may be formed simultaneously with the storage capacitor 60. More particularly, the trench 82 of the capacitor 80 is formed simultaneously with the trench 81 of the storage capacitor 60 of the memory cell 61. Also, the dielectric film 30 and the upper electrode 37 are simultaneously formed with the film 10 and electrode 7 of the memory cell. Therefore, the depth of the two trenches 81, 82 is the same, and the thickness and material of the films 10 and 30 are respectively the same. The material is common to the both electrodes 7 and 37. Thus, no additional process step is necessary to form the capacitor 80 of the present invention. When the power source voltage Vcc (for example, + 5V) is applied to the upper electrode 37 through the wiring 31, the N-type inversion layer 33 is produced all under the film 30 in the trench 82 which is employed as the lower electrode of the capacitor 80. The electrons 16″ dispersed from the depletion layer 16 in the peripheral circuit section 200 can be effectively absorbed by the potential distribution formed in the substrate near the capacitor 80. Therefore, the dispersed electrons 16″ are prevented from reaching the storage capacitor 60 of the memory cell, so that the erroneous operation can be avoided. The potential distribution and the physical shading shape of the trench contribute to effectively prevent the electrons 16″. The width of the trench 82 of the capacitor 80 is 1.5 µm which is the same value of the trench 81 of the storage capacitor 60. Therefore, the capacitance of the capacitor 80 becomes about 50 fF at a distance of 1.5 µm in the plan view (Fig. 2).

On the other hand, when the N-type layer 33 is formed beforehand, the upper electrode 37 may be supplied with 0 V (ground potential) or with the same potential as the substrate 1. In this case, the electrons 16″ are reflected towards the peripheral circuit by a potential distribution formed in the substrate near the capacitor 80, not reaching the storage capacitor 60 of the memory cell. If the N-type layer 33 is not formed and the potential applied to the upper electrode 37 is 0 V, the same effect can be expected.

In Fig. 2, the capacitor 80 in the capacitor section 300 surrounds completely each memory cell section 100. However, it is not necessary to form the capacitor 80 between a memory cell and such an element 71 in the peripheral circuit 70 that does not produce high energy electrons. Therefore, the capacitor 80 not necessarily completely surrounds the memory array section 100, but the capacitor 80 may be omitted partially from the periphery of the memory array section 100.

Referring to Fig. 4, in which the same components as those in Fig. 3 are indicated by the same reference numerals and the components other than storage capacitors 60 are not shown in the memory array section 100, the capacitor 80 according to this embodiment is formed in the trench 82′ which is deeper than the trench 81 of the storage capacitor 60 of the memory cell. Although a process step for forming the deep trench 82′ must be added, electrons from the peripheral element 71 are more effectively prevented.

Referring to Fig. 5, the same components as those in Fig. 3 are indicated by the same reference numerals. In this embodiment, the storage capacitor 60′ of the memory cell consists of a dielectric fiom 58 formed on the flat major surface 18 of the substrate 1, an upper electrode 57 of polycrystalline formed on the dielectric film 58 and an N-type layer 53 induced at the surface 18 of the substrate by the positive potential Vcc (+5V) applied to the gate electrode 57. The N-type layer 53 may be formed beforehand, and, in that case, the upper electrode may be connected to a ground line. No trench is formed in the storage capacitor of the memory cell. Also, the capacitor 90 of the present invention installed in the capacitor section 300 is formed along the flat major surface of the substrate and no trench is formed. That is, the capacitor 90 includes a flat dielectric film 55, an upper electrode 56 formed on the dielectric film 56 and an N-type layer 54 produced by a possitive potential such as Vcc of 5V applied to the upper electrode 56 through the power source line 31 or provided beforehand. When the positive voltage, for example, +5 V is applied to the upper electrode 56, the stray electrons 16″ from the depletion layer 13 can be effectively absorbed·in the capacitor 90 by the potential distribution in the substrate near the capacitor produced by the positive voltage, and do not travel to the storage capacitor 60′ of the memory cell. On the other hand, when the upper electrode 56 maintains ground potential the electrons 16″ are reflected back to the peripheral circuit 200.

## Claims

1. A semiconductor memory device comprising a semiconductor substrate, a memory cell array section provided in a first portion of said substrate and having a plurality of memory cells therein, a peripheral circuit section provided in a second portion of said substrate in the vicinity of said first portion and with a peripheral circuit formed therein, and a capacitor substantially surrounding said memory cell array section.

2. A semiconductor memory device comprising a semiconductor substrate having a major surface, a memory cell including a switching transistor and a storage capacitor coupled to said switching transistor, a circuit element belonging to a peripheral circuit, and an isolation capacitor positioned between said storage capacitor of said memory cell and said circuit element in said peripheral circuit.

3. A semiconductor memory device of Claim 2, in which said storage capacitor is formed in a first trench extending from said major surface of said substrate inward said substrate with a dielectric film attached to the side and bottom surfaces of said first trench and an upper electrode provided on said dielectric film, and said isolation capacitor is formed in a second trench extending from said major surface of said substrate inward said substrate with a dielectric film attached to the side and bottom surfaces of said second trench and an upper electrode provided on said dielectric film.

4. A semiconductor memory device of Claim 3, in which the depth of said second trench is equal to that of said first trench.

5. A semiconductor memory device of Claim 3, in which the depth of said second trench is deeper than that of said first trench.

6. A semiconductor memory device of Claim 2, in which said storage capacitor of said memory cell is formed along the flat major surface of said substrate, and said capacitor between said storage capacitor and said circuit element is formed along the flat major surface of said substrate.

7. A semiconductor memory device of Claim 3 further comprising an impurity region having the conductivity type opposite to that of said substrate formed in said substrate under said upper electrode.

8. A semiconductor memory device of Claim 7, in which said impurity region is an inversion layer produced when a power supply voltage is applied to said upper electrode.

9. A semiconductor memory device of Claim 8, in which said substrate is of P-type and said impurity region is of N-type, the polarity of said voltage being positive.

Fig. 1 ( Prior Art )

Fig. 3

Fig. 2

Fig. 4

Fig. 5